# EUROPÄISCHE PATENTSCHRIFT

(11) **EP 2 986 751 B1**
(45) Veröffentlichungstag und Bekanntmachung des Hinweises auf die Patenterteilung: **12.06.2019**
(21) Anmeldenummer: 14723323.3
(22) Anmeldetag: 15.04.2014
(51) Int. Cl.: C23C 8/34, C23C 8/36, C21D 9/00, C21D 1/06

(54) **VERFAHREN UND VORRICHTUNG FÜR DAS THERMOCHEMISCHE HÄRTEN VON WERKSTÜCKEN**
METHOD AND APPARATUS FOR THE THERMOCHEMICAL HARDENING OF WORKPIECES
PROCÉDÉ ET DISPOSITIF AU DURCISSEMENT THERMOCHIMIQUE DES PIÈCES

(30) Priorität: 17.04.2013 DE 102013006589
(43) Veröffentlichungstag der Anmeldung: 24.02.2016
(73) Patentinhaber: ALD Vacuum Technologies GmbH, 63457 Hanau (DE)
(72) Erfinder: HEUER, Volker, 60596 Frankfurt (DE); LÖSER, Klaus, 63533 Mainhausen (DE)
(74) Vertreter: Plate, Jürgen
(86) Internationale Anmeldenummer: PCT/EP2014/001017
(87) Internationale Veröffentlichungsnummer: WO 2014/170022

(56) Entgegenhaltungen:
- EP-A1- 0 735 149
- EP-A2- 1 247 875
- DE-C1- 10 118 244
- US-B1- 6 235 128
- NISHIMOTO A ET AL: "Effect of Through Cage on Active Screen Plasma Nitriding Properties", MATERIALS TRANSACTIONS, Bd. 50, Nr. 5, 2. April 2009 (2009-04-02), Seiten 1169-1173, XP055129475, The Japan Institute of Metals and Materials, Sendai [JP] ISSN: 1345-9678, DOI: 10.2320/matertrans.MRA2008431

## Beschreibung

Aus EP 1 247 875 A ist ein Verfahren zur Niederdruck-Karbonitrierung von Stahlteilen bekannt, bei dem die Teile in einem Temperaturbereich von vorzugsweise bei etwa 850 °C bis 950 °C mit einem Kohlenstoffspendergas bei einem Druck besonders bevorzugt unter 50 hPa aufgekohlt werden und anschließend mit NH₃ als Stickstoffspendergas aufgestickt werden.

EP 0 735 149 A offenbart eine Vorrichtung zur mehrstufigen, thermochemischen Vakuumhärtung von Werkstücken. Die Vorrichtung umfasst einen Rundtaktofen mit einer ringförmigen Transferkammer, an die evakuierbare Kammern, welche als Plasmaöfen ausgelegt sein können, angeschlossen sind.

DE 101 18 244 C offenbart eine modulare Vorrichtung zur thermochemischen Härtung und Abschreckung von Werkstücken. Die Vorrichtung umfasst mehrere Behandlungszellen, bei denen es sich um Vakuumkammern mit jeweils einer vakuumtauglichen Tür handelt, in denen Werkstücke behandelt werden. Parallel zu den in einer Reihe angeordneten Behandlungszellen verläuft eine Schiene, auf der sich ein Schienenwagen befindet. Auf dem Schienenwagen befindet sich eine verfahrbare Abschreckkammer mit einer vakuum- und druckfesten Tür. Außerdem befindet sich auf dem Schienenwagen im Anschluß an die Abschreckkammer eine vakuumdichte Umsetzkammer, an deren einem Ende ein vakuumtauglicher Andockmechanismus vorgesehen ist. Mit einem Schienentransportsystem werden die Chargen aus einer der Behandlungszellen über die Umsetzkammer zu der Abschreckkammer gebracht.

Die vorliegende Erfindung betrifft ein Verfahren und eine Vorrichtung zum thermochemischen Härten von Werkstücken, umfassend in variabler Reihenfolge
- einen oder mehrere Aufkohl-Schritte, jeweils in einer kohlenstoffhaltigen Gasatmosphäre mit einem Druck von kleiner 50 mbar, wobei die Werkstücke auf Temperaturen von 900 bis 1050 °C gehalten werden;
- gegebenenfalls einen oder mehrere Diffusions-Schritte, jeweils in einer Gasatmosphäre mit einem Druck von kleiner 100 mbar; und
- einen oder mehrere Aufstick-Schritte, jeweils in einer stickstoffhaltigen Gasatmosphäre mit einem Druck von kleiner 50 mbar, wobei die Werkstücke auf Temperaturen von 800 bis 1050 °C gehalten werden.

Die vorliegende Erfindung hat die Aufgabe, ein Verfahren und eine Vorrichtung für das thermochemische Härten von Werkstücken mittels Aufkohlen und Aufsticken bereitzustellen, welche die folgenden Vorteile aufweisen:
- präzise Einstellung der Kohlenstoff- und Stickstoffprofile in der Randzone der Werkstücke;
- hohe Produktiviät und flexible Chargierung; und
- verminderter Energieverbrauch und Umweltbelastung.

Diese Aufgabe wird gelöst durch ein Verfahren, umfassend in variabler Reihenfolge
- einen oder mehrere Aufkohl-Schritte, jeweils in einer kohlenstoffhaltigen Gasatmosphäre mit einem Druck von kleiner 50 mbar, wobei die Werkstücke auf Temperaturen von 900 bis 1050 °C gehalten werden;
- gegebenenfalls einen oder mehrere Diffusions-Schritte, jeweils in einer Gasatmosphäre mit einem Druck von kleiner 100 mbar; und
- einen oder mehrere Aufstick-Schritte, jeweils in einer stickstoffhaltigen Gasatmosphäre mit einem Druck von kleiner 50 mbar, wobei die Werkstücke auf Temperaturen von 800 bis 1050 °C gehalten werden, die stickstoffhaltige Gasatmosphäre als Spendergas molekularen Stickstoff (N₂) enthält und mittels eines Entladungsplasmas angeregt wird; wobei
- das Verfahren derart geführt wird, dass Zeitintervalle zwischen zwei aufeinander folgenden Verfahrensschritten kürzer als 15 min sind und die Werkstücke während dieser Zeitintervalle in einer Gasatmosphäre mit einem Druck von kleiner 300 mbar gehalten werden.

Vorteilhafte Weiterbildungen des erfindungsgemäßen Verfahrens sind dadurch gekennzeichnet, dass
- die Zeitintervalle zwischen zwei aufeinander folgenden Verfahrensschritten kürzer als 10 min, vorzugsweise kürzer als 5 min und insbesondere kürzer als 1 min sind;
- die Werkstücke in einem Zeitintervall zwischen zwei aufeinander folgenden Verfahrensschritten in einer Gasatmosphäre mit einem Druck von kleiner 200 mbar, vorzugsweise kleiner 100 mbar gehalten werden;
- die Temperatur der Werkstücke in einem Zeitintervall zwischen zwei aufeinander folgenden Verfahrensschritten größer 600 °C, vorzugsweise größer 700 °C und insbesondere größer 800 °C ist;
- das Verfahren in sequentieller Folge die Schritte
   - Aufkohlen / Aufsticken;
   - Aufkohlen / Diffundieren / Aufsticken;
   - Aufsticken / Aufkohlen / Aufsticken;
   - Aufsticken / Aufkohlen / Aufsticken / Aufkohlen; oder
   - Aufsticken / Aufkohlen / Diffundieren / Aufsticken
   umfasst;
- das Entladungsplasma mit einer gegebebenfalls gepulsten Gleichspannung von 200 bis 1000 V, einem Gleichstrom von 10 bis 200 A und einer kontinuierlichen Leistung von 2 bis 200 kVA betrieben wird;
- in einem oder mehreren der Aufstick-Schritte die stickstoffhaltige Gasatmosphäre mittels eines gepulsten Gleichstrom-Entladungsplasmas, bevorzugt in Verbindung mit Zündimpulsen angeregt wird;
- in einem oder mehreren der Aufstick-Schritte das Entladungsplasma mithilfe einer Aktivgitterelektrode erzeugt wird;
- die Werkstücke auf einem relativ zur Aktivgitterelektrode negativen elektrischen Potential (Biasspannung) mit einem Betrag von 10 bis 400 Volt, vorzugsweise von 10 bis 200 V gehalten werden;
- die Werkstücke auf einem relativ zur Aktivgitterelektrode negativen elektrischen Potential (Biasspannung) gehalten werden, wobei der Betrag des negativen Potentials an den Werkstücken 2- bis 12-fach so groß wie der Betrag des negativen Potentials der Aktivgitterelektrode ist;
- in einem oder mehreren der Aufstick-Schritte Plasma-Immersion-Ionen-Implantation eingesetzt wird;
- die Werkstücke während der Aufstick-Schritte auf Temperaturen von 820 bis 1000 °C, vorzugsweise 920 bis 980 °C gehalten werden;
- die Werkstücke während der Aufkohl-Schritte auf Temperaturen von 940 bis 1050 °C gehalten werden;
- in den Aufstick-Schritten die stickstoffhaltige Gasatmosphäre aus N₂ und gegebenenfalls einem oder mehreren Trägergasen, wie H₂ und Argon besteht;
- in den Aufstick-Schritten die stickstoffhaltige Gasatmosphäre aus N₂ und einem oder mehreren kohlenstoffhaltigen Gasen, wie CO₂ oder CH₄ sowie gegebebenenfalls einem oder mehreren Trägergasen, wie H₂ und Argon besteht;
- in den Aufstick-Schritten der Anteil der kohlenstoffhaltigen Gase, bezogen auf N₂ , 2 bis 20 Vol.-%, vorzugsweise 4 bis 15 Vol-% und insbesondere 4 bis 10 Vol-% beträgt;
- in den Aufstick-Schritten der Druck der stickstoffhaltigen Gasatmosphäre kleiner 40 mbar, vorzugsweise kleiner 30 mbar und insbesondere kleiner 20 mbar ist;
- in den Aufkohl-Schritten die kohlenstoffhaltige Gasatmosphäre aus einem oder mehreren kohlenstoffhaltigen Spendergasen, wie C₂H₂, CO₂ und CH₄ und gegebenenfalls einem oder mehreren Trägergasen, wie H₂ und Argon besteht;
- in den Aufkohl-Schritten der Druck der kohlenstoffhaltigen Gasatmosphäre kleiner 40 mbar, vorzugsweise kleiner 30 mbar und insbesondere kleiner 20 mbar ist;
- das Verfahren einen Hochdruck-Diffusions-Schritt in einer N₂-Atmosphäre mit einem Druck von 0,9 bis 2 bar umfasst; und/oder
- das Verfahren in sequentieller Folge die Schritte
   - Aufsticken / Aufkohlen / Hochdruck-Diffundieren
umfasst.

Im Weiteren hat die vorliegende Erfindung die Aufgabe, eine Vorrichtung zu schaffen, mit der die Kohlenstoff- und Stickstoffprofile in der Randzone der Werkstücke präzise eingestellt werden können und eine hohe Produktiviät und flexible Chargierung bei vermindertem Energieverbrauch und ohne Umweltbelastung erzielbar sind.

Diese Aufgabe wird gelöst durch eine Vorrichtung, umfassend
- m Niederdruck-Heizkammern mit m = 2, 3, 4, 5, 6, 7, 8, 9, oder 10;
- eine an die Niederdruck-Heizkammern angeschlossene Gasversorgung, die dafür eingerichtet ist, die Niederdruck-Heizkammern mit einem oder mehreren Gasen, gewählt aus der Gruppe umfassend N₂ , kohlenstoffhaltige Spendergase, wie C₂H₂ , CO₂ und CH₄ und Trägergase, wie H₂ und Argon zu versorgen;
- eine Transferkammer, an die jede der Niederdruck-Heizkammern sowie eine Schleusenkammer und eine Abschreckkammer oder eine bifunktionale Schleusen-Abschreck-Kammer angebunden ist; oder
- eine Schleusenkammer und eine Abschreckkammer, die jeweils verfahrbar und mit jeder der Niederdruck-Heizkammern verbindbar sind; oder
- eine bifunktionale Schleusen-Abschreck-Kammer, die verfahrbar und mit jeder der Niederdruck-Heizkammern verbindbar ist; wobei
eine oder mehrere der Niederdruck-Heizkammern mit einer elektrischen Energieversorgung verbunden und dafür eingerichtet sind, in einer stickstoffhaltigen Gasatmosphäre mit N₂ als Spendergas bei Temperaturen von über 800 °C und Drücken von kleiner 100 mbar ein Entladungsplasma zu erzeugen, wobei
- die elektrische Energieversorgung eingerichtet ist für den Betrieb eines Entladungsplasmas mit einer Gleichspannung von 200 bis 1000 V, einem Gleichstrom von 10 bis 200 A und einer kontinuierlichen Leistung von 2 bis 200 kVA.
   Bevorzugt ist, dass
- die elektrische Energieversorgung für den Betrieb mit gepulster Gleichspannung, vorzugsweise in Verbindung mit Zündimpulsen eingerichtet ist; und/oder
- eine oder mehrere der Niederdruck-Heizkammern mit einer Aktivgitterelektrode ausgerüstet sind.

Vorzugsweise umfasst das erfindungsgemäße Verfahren in sequentieller Folge die Schritte:
- Laden / Evakuieren / Aufkohlen / Aufsticken / Abschrecken / Entladen;
- Laden / Evakuieren / Aufkohlen / Diffundieren / Aufsticken / Abschrecken / Entladen;
- Laden / Evakuieren / Aufsticken / Aufkohlen / Aufsticken / Abschrecken / Entladen;
- Laden / Evakuieren / Aufsticken / Aufkohlen / Aufsticken / Aufkohlen / Abschrecken / Entladen;
   oder
- Laden / Evakuieren / Aufsticken / Aufkohlen / Diffundieren / Aufsticken / Abschrecken / Entladen.

Das Evakuieren erfolgt in einer Schleusenkammer oder in einer bifunktionalen Schleusen-Abschreck-Kammer. Im Weiteren wird zwecks sprachlicher Vereinfachung der Verfahrensschritt des Evakuierens lediglich in Verbindung mit einer Schleusenkammer beschrieben. Erfindungsgemäß ist hierbei stets auch die Alternative des Evakuierens in einer bifunktionalen Schleusen-Abschreck-Kammer einbegriffen.

Die zu behandelnden Werkstücke werden direkt auf einem vorzugsweise platten- oder gitterförmig ausgebildeten Chargenträger gelegt und/oder in einem Chargengestell angeordnet und das Chargengestell gegebenenfalls auf den Chargenträger gestellt. Längliche Werkstücke, wie Getriebewellen werden vorzugsweise hängend in dem Chargenträger oder Chargengestell angeordnet.

Die erfindungsgemäße Vorrichtung umfasst ein aus einem oder mehreren Modulen aufgebautes Chargentransportsystem, wobei je ein Modul einer Transferkammer und/oder einer oder mehreren Schleusenkammern, Abschreckkammern und Niederdruck-Heizkammern zugeordnet ist. Jedes Modul des Chargentransportsystems ist mit Stellgliedern ausgerüstet, die über elektrische Kabel mit einer zentralen Steuerung der Vorrichtung, wie beispielsweise einer speicherprogrammierbaren Steuerung (SPS) verbunden sind.

Eine bevorzugte Ausführungsform der erfindungsgemäßen Vorrichtung umfasst eine stationäre bifunktionale Schleusen-Abschreck-Kammer, m vertikal übereinander angeordnete Niederdruck-Heizkammern mit m = 2, 3, 4, 5, 6, 7, 8, 9 oder 10 sowie eine Transferkammer, wobei die bifunktionale Schleusen-Abschreck-Kammer und die Niederdruck-Heizkammern an die Transferkammer angeschlossen sind. Jede der Niederdruck-Heizkammern ist mit einem Vakuumschieber oder einer Vakuumtür ausgerüstet, mit welcher der Innenraum der Niederdruck-Heizkammer gasdicht von dem Innenraum der Transferkammer getrennt werden kann. Die bifunktionale Schleusen-Abschreck-Kammer ist mit zwei einander gegenüberliegend angeordneten Vakuumschiebern oder Vakuumtüren ausgestattet.

In allen erfindungsgemäßen Vorrichtungen werden wahlweise vertikal oder horizontal verfahrbare Vakuumschieber und/oder schwenkbare Vakuumtüren verwendet. Vakuumschieber und Vakuumtüren sind kommerziell in vielfältigen Bauformen und Abmessungen erhältlich.

Eine weitere bevorzugte Ausfiihrungsform der erfindungsgemäßen Vorrichtung umfasst eine stationäre Schleusenkammer, eine stationäre Abschreckkammer, m vertikal übereinander angeordnete Niederdruck-Heizkammern mit m = 2, 3, 4, 5, 6, 7, 8, 9 oder 10 sowie eine Transferkammer, wobei die Schleusenkammer, die Abschreckkammer und die Niederdruck-Heizkammern an die Transferkammer angeschlossen sind. Jede der Niederdruck-Heizkammern ist mit einem Vakuumschieber oder einer Vakuumtür ausgerüstet, mit welcher der Innenraum der Niederdruck-Heizkammer gasdicht von dem Innenraum der Transferkammer getrennt werden kann. Die Schleusenkammer und die Abschreckkammer sind jeweils mit zwei einander gegenüberliegend angeordneten Vakuumschiebern oder Vakuumtüren ausgestattet.

In den beiden vorstehenden Vorrichtungen ist das Chargentransportsystem im Wesentlichen in der Transferkammer angeordnet und umfasst einen Aufzug mit vertikalem Fahrweg in Verbindung mit einem Teleskopmechanismus für die Aufnahme und horizontale Verfahrung eines Chargenträgers und/oder Chargengestells mit Werkstücken.

Eine weitere bevorzugte Ausführungsform der erfindungsgemäßen Vorrichtung umfasst eine stationäre Schleusenkammer, eine stationäre Abschreckkammer, m horizontal und kreisförmig nebeneinander angeordnete Niederdruck-Heizkammern mit m = 2, 3, 4, 5, 6, 7, 8, 9 oder 10 sowie eine Transferkammer, wobei die Schleusenkammer, die Abschreckkammer und die Niederdruck-Heizkammern an die Transferkammer angeschlossen sind. Jede der Niederdruck-Heizkammern ist mit einem Vakuumschieber oder einer Vakuumtür ausgerüstet, mit welcher der Innenraum der Niederdruck-Heizkammer gasdicht von dem Innenraum der Transferkammer getrennt werden kann. Die Schleusenkammer und die Abschreckkammer sind jeweils mit zwei einander gegenüberliegend angeordneten Vakuumschiebern oder Vakuumtüren ausgestattet. In einer derartig konfigurierten Vorrichtung umfasst ein in der Transferkammer angeordnetes Chargentransportsystem einen angetriebenen Drehteller in Verbindung mit einem Teleskopmechanismus für die Aufnahme und horizontale Verfahrung eines Chargenträgers und/oder Chargengestells mit Werkstücken.

Bevorzugt sind die Niederdruck-Heizkammern für das thermochemische Härten von Werkstücken vorgesehen, die in einem Chargenstapel mit 1 bis 10 horizontalen Lagen, insbesondere ein, zwei, drei, vier oder fünf horizontalen Lagen angeordnet sind, wobei in einer horizontalen Lage jeweils mehrere Werkstücke flächig verteilt nebeneinander und vorzugsweise voneinander beabstandet angeordnet sind. Dementsprechend sind die Niederdruck-Heizkammern derart dimensioniert, dass das freie Chargiervolumen eine Breite und hiervon unabhängig eine Länge von jeweils 400 bis 1000 mm, vorzugsweise 400 bis 800 mm und eine Höhe von 100 bis 300 mm, vorzugsweise 100 bis 200 mm hat, bei einem lichten Abstand zwischen dem Chargiervolumen und den Innenwänden der Niederdruck-Heizkammer sowie den Heizelementen von 20 bis 40 mm.

Mindestens eine der Niederdruck-Heizkammern ist für das Aufsticken mittels eines Entladungsplasmas vorgesehen und mit einer elektrischen Energieversorgung verbunden. Um an einen Chargenträger mit Werkstücken ein negatives Potential anlegen zu können, ist die Niederdruck-Heizkammer vorzugsweise mit einem flächenhaft ausgebildeten elektrischen Kontakt ausgerüstet. Der elektrische Kontakt ist mit einem elektrischen Leiter verbunden, der von dem Kontakt bzw. von der Innenseite der Niederdruck-Heizkammer durch die Wand der Niederdruck-Heizkammer nach außen führt und an die elektrische Energieversorgung angeschlossen ist.

Grundsätzlich ist es nicht erforderlich, an die Werkstücke ein negatives Potential zu legen. Vielmehr können die Werkstücke bezogen auf die Innenwand einer Niederdruck-Heizkammer und bezogen auf Massepotential elektrisch isoliert sein - bzw. auf einem schwebenden, sich im Entladungsplasma selbsttätig einstellenden Potential liegen.

Nichtdestoweniger ist im Rahmen der Erfindung vorgesehen, an die Werkstücke ein negatives Potential zu legen. In einer vorteilhaften Ausführungsform umfasst der Chargenträger eine Trägerplatte mit vier Stellfüßen. Die Trägerplatte und mindestens einer der Stellfüße sind aus einem elektrisch leitfähigen Material, wie einem Metall, einer Metalllegierung, Grafit oder Carbonfaser-verstärktem Grafit (CFC) gefertigt. Der elektrisch leitfähige Stellfuß ist vorgesehen zur Positionierung auf einem flächenhaft ausgebildeten elektrischen Kontakt in den Niederdruck-Heizkammern.

Eine alternative Ausführungsform der erfindungsgemäßen Vorrichtung umfasst ein Chargentransportsystem mit Modulen, die in Schleusenkammern, Abschreckkammern, Niederdruck-Heizkammern und gegebenenenfalls in einer Transferkammer angeordnet sind. Ein für ein derartiges Chargentransportsystem eingerichteter Chargenträger weist in einem unteren Bereich ein erstes Kupplungselement sowie gegebenenfalls Rollen auf. Das Chargentransportsystem bzw. dessen verschiedene, in Schleusenkammern, Abschrecckammern, Niederdruck-Heizkammem und gegebenenfalls in einer Transferkammer angeordneten Module sind mit zweiten Kupplungselementen ausgerüstet, welche passend zu dem ersten Kupplungselement ausgebildet und lösbar mit diesem koppelbar sind. Die Module des Chargentransportsystems sind derart ausgebildet, dass ein Chargenträger mit Werkstücken von einer Kammer mittels Stellgliedern, wie elektrischen Linearantrieben in eine hierzu benachbarte Kammer übergeben werden kann. Das zweite Kupplungselement des Chargentransportsystems der für das Aufsticken bestimmten Niederdruck-Heizkammern ist elektrisch leitfähig ausgebildet. Beispielweise besteht das zweite Kupplungselement aus einem leitfähigen Material, wie einem Metall, einer Metalllegierung, Grafit oder Carbonfaser-verstärktem Grafit (CFC). Alternativ hierzu ist das zweite Kupplungselement mit einem elektrischen Kabel ausgerüstet sowie mit einem mit dem Kabel verbundenen elektrischen Kontakt für einen Chargenträger bzw. für ein an einem Chargenträger befindliches erstes Kupplungselement. Der elektrische Kontakt ist vorzugsweise als Feder-, Schleif- oder Bürstenkontakt ausgebildet.

In einer zweckmäßigen Weiterbildung der erfindungsgemäßen Vorrichtung sind die für das Aufsticken vorgesehenen Niederdruck-Heizkammern mit einem Drehantrieb ausgerüstet. Der Drehantrieb ermöglicht es, den Chargenträger mit den Werkstücken während des Aufstickens in einem Entladungsplasma kontinuierlich zu drehen, um - gemittelt über die Zeitdauer des Aufstickens - eine gleichmäßige Beaufschlagung der Werkstücke mit dem Entladungsplasma zu gewährleisten. Eine Rotation des Chargenträgers mit den Werkstücken erweist sich als besonders vorteilhaft, wenn zur Erzeugung des Entladungsplasmas eine Aktivgitterelektrode verwendet wird, welche sich lediglich entlang drei oder zwei Seitenwänden und/oder entlang der Decke einer Niederdruck-Heizkammer erstreckt. Für die Beladung und Entladung einer Niederdruck-Heizkammer zum Aufsticken wird zweckmäßig eine Aktivgitterelektrode mit einer oder gegebenenfalls zwei einander gegenüberliegenden Öffnungen verwendet. Alternativ hierzu ist im Rahmen der Erfindung eine verfahrbare oder eine faltbare Aktivgitterelektrode vorgesehen, welche zum Laden und Entladen der Niederdruck-Heizkammer so positioniert bzw. angestellt wird, dass eine Kollision mit dem Chargenträger und den Werkstücken vermieden wird.

In einem ersten Ladeschritt wird der Chargenträger mit den Werkstücken in eine Schleusenkammer (bzw. in eine bifunktionale Schleusen-Abschreck-Kammer) eingebracht. Die Schleusenkammer wird vakuumdicht verschlossen und mittels Pumpen evakuiert. Nachdem der Druck der die Werkstücke umgebenden Gasatmosphäre auf einen Wert von kleiner 300 mbar, vorzugsweise kleiner 200 mbar und insbesondere kleiner 100 mbar reduziert ist, werden die Werkstücke - abhängig von der jeweiligen Konfiguration der erfindungsgemäßen Vorrichtung - von der Schleusenkammer in eine Transferkammer und von der Transferkammer in eine Niederdruck-Heizkammer übergeben oder die Schleusenkammer vor einer bereits evakuierten Niederdruck-Heizkammer positioniert und vakuumdicht an die Niederdruck-Heizkammer gekoppelt.

Um eine verfahrbare Schleusenkammer vakuumdicht mit einer Niederdruck-Heizkammer zu zu verbinden, ist die Schleusenkammer und gegebenenfalls die Niederdruck-Heizkammer mit Kupplungselementen einer ein- oder zweiteilig ausgebildeten Vakuumkupplung ausgerüstet. Zweckmäßig umfasst die Vakuumkupplung zwei Flansche mit zueinander passenden Dichtflächen, wobei die Dichtfläche eines der Flansche mit einem O-Ring ausgerüstet ist und einer der Flansche einen ringförmig umlaufenden Vorsprung aufweist, welcher die Dichtflächen abschirmt gegenüber Strahlung und heißem Restgas aus der Niederdruck-Heizkammer.

Sobald sich der Chargenträger mit den Werkstücken in einer Niederdruck-Heizkammer befindet, wird diese vakuumdicht verschlossen und auf einen Druck von kleiner 50 mbar, kleiner 40 mbar, kleiner 30 mbar, vorzugsweise kleiner 20 mbar evakuiert. Die Niederdruck-Heizkammer ist elektrisch beheizt und hat bei Übergabe des Chargenträgers mit den Werkstücken bereits eine Temperatur von größer 600 °C, vorzugsweise größer 700 °C und insbesondere größer 800 °C. Bei Übergabe der ersten Charge eines Produktionslaufes kann die Niederdruck-Heizkammer auch eine Temperatur von kleiner 600 °C haben. Je nach Anfangstemperatur bei Übergabe des Chargenträgers wird der Niederdruck-Heizkammer über einen bestimmten Zeitraum eine festgelegte Menge elektrischer Energie (kWh) zugeführt, um die Temperatur der Werkstücke auf 800 bis 1050 °C für das Aufsticken, auf 900 bis 1050 °C für das Aufkohlen oder 800 bis 1050 °C für das Diffundieren einzustellen. Vorzugsweise umfasst jede der Niederdruck-Heizkammern Pyrometer, Bolometer oder Thermoelemente zum Messen der Temperatur der Werkstücke. Nachdem die Werkstücke die gewünschte Arbeitstemperatur erreicht und über eine vorgegebene Verweilzeit gehalten haben, werden der Niederdruck-Heizkammer kontinuierlich ein oder mehrere Prozessgase, wie N₂, C₂H₂, CH₄, CO₂, H₂, Argon in kontrollierter Weise zugeführt, um eine für das Aufsticken, Aufkohlen oder Diffundieren geeignete Gasatmosphäre zu erzeugen. Zugleich wird die Niederdruck-Heizkammer fortlaufend mittels einer oder mehrerer Vakuumpumpen evakuiert, um den Druck auf einem vorgegebenen Wert von kleiner 50 mbar, kleiner 40 mbar, kleiner 30 mbar, vorzugsweise kleiner 20 mbar zu halten. Der kurzzeitige Volumenstrom für das bzw. die Prozessgase in einer Niederdruck-Heizkammer beträgt maximal 1500 l/h (Liter pro Stunde) vorzugsweise 150 bis 800 l/h. In den Aufstickkammern beträgt der maximale Volumen-strom des Prozessgases 1000 l/h, vorzugsweise 20 bis 600 l/h, 20 bis 400 l/h und insbesondere 20 bis 300 l/h.

Die Dauer eines Aufstick-, Aufkohl- oder Diffusions-Schrittes beträgt zwischen 5 und 150 min. Sofern ein nachfolgender Aufstick-, Aufkohl- oder Diffusions-Schritt vorgesehen ist, kann dieser in der gleichen oder in einer anderen Niederdruck-Heizkammer ausgeführt werden. Erfindungsgemäß ist es bevorzugt, Aufstick- und Aufkohl-Schritte in voneinander verschiedenen Niederdruck-Heizkammern durchzuführen, so dass eine Niederdruck-Heizkammer auschließlich für das Aufsticken oder ausschließlich für das Aufkohlen und gegebenenfalls für das Diffundieren verwendet wird. Durch die Ausführung von Aufstick- und Aufkohl-Schritten in getrennnten Niederdruck-Heizkammern werden durch Kreuzkontamination verursachte Probleme, wie beispielsweise die Bildung von Blausäure (HCN) weitgehend vermieden. Zudem kann eine Kontamination des Aufstickplasmas mit Kohlenstoff vermieden werden.

Für einen nachfolgenden Aufstick-, Aufkohl- oder Diffusions-Schritt in einer anderen, für diesen Verfahrensschritt vorgesehenen Niederdruck-Heizkammer wird der Chargenträger mit den Werkstücken zurück in die Transferkammer oder in eine verfahrbare Schleusenkammer und von dieser in die besagte Niederdruck-Heizkammer überführt. Alternativ hierzu sind im Rahmen der Erfindung auch Vorrichtungen vorgesehen, in welchen zwei Niederdruck-Heizkammern nebeneinander angeordnet und über eine Öffnung mit einem Vakuumschieber oder einer Vakuumtür miteinander verbindbar sind. In derartig konfigurierten Vorrichtungen ist die erste Niederdruck-Heizkammer beispielsweise für das Aufkohlen und/oder Diffundieren und die zweite Niederdruck-Heizkammer für das Diffundieren und/oder das Aufsticken vorgesehen.

Nach Ausführung sämtlicher Aufstick-, Aufkohl- und Diffusions-Schritte wird der Chargenträger mit den Werkstücken in der vorstehend beschriebenen Weise in eine Abschreckkammer (bzw. bifunktionale Schleusen-Abschreck-Kammer) transferiert und in bekannter Weise, bevorzugt mittels eines Gases abgeschreckt. Alternativ zur Abschreckung mittels Gas ist im Rahmen der Erfindung auch die Abschreckung mittels Öl oder einem Polymer vorgesehen.

Die erfindungsgemäße Vorrichtung umfasst zwei, drei, vier, fünf, sechs, sieben, acht, neun oder zehn elektrisch heizbare Niederdruck-Heizkammern, welche jeweils über Gasleitungen an separate Gasversorgungen oder an eine zentrale Gasversorgung angeschlossen sind. Die Gasversorgungen umfassen mehrere Behälter für Prozessgase, gewählt aus der Gruppe umfassend N₂ , kohlenstoffhaltige Spendergase, wie C₂H₂, CO₂ und CH₄ und Trägergase, wie H₂ und Argon. In den Gasleitungen sind Massenflussregler (Mass-Flow-Controller) angeordnet, welche es ermöglichen die den Niederdruck-Heizkammern pro Zeiteinheit zugeführte Gasmenge zu regeln. Die Massenflussregler sind über elektrische Kabel mit einer zentralen Steuerung der Vorrichtung, wie beispielsweise einer speicherprogrammierbaren Steuerung (SPS) verbunden. Jede Niederdruck-Heizkammer ist mit einem oder mehreren Heizelementen ausgerüstet, die vorzugsweise aus Grafit, oder aus Carbonfaser-verstärktem Grafit (CFC) bestehen und elektrisch betrieben werden. Jede Niederdruck-Heizkammer ist mit einer oder mehreren Vakuumpumpen oder mit einem zentralen Pumpenstand verbunden.

Zweckmäßig sind die Schleusen- und Abschreckkammern sowie die Niederdruck-Heizkammern und gegebenenfalls die Transferkammer jeweils mit Drucksensoren ausgerüstet, welche über elektrische Kabel mit einer zentralen Steuerung der Vorrichtung, wie einer Speicher-programmierbaren Steuerung (SPS) verbunden sind.

Jede der Niederdruck-Heizkammern weist eine oder zwei Öffnungen sowie einen oder zwei Vakuumschieber oder Vakuumtüren auf, die an einer oder zwei einander gegenüberliegenden Stirnseiten der Niederdruck-Heizkammern angeordnet sind.

In einer alternativen Weiterbildung der erfindungsgemäßen Vorrichtung sind die Niederdruck-Heizkammern an zwei gegenüberliegenden Stirnseiten mit einer ersten und zweiten Öffnung und einem ersten und zweiten Vakummschieber oder einer ersten und zweiten Vakuumtür ausgestattet. Hierin wird ein Chargenträger mit Werkstücken durch eine erste Öffnung in eine Niederdruck-Heizkammer geladen und nach Beendigung eines Aufstick-, Aufkohl- oder Diffusions-Schrittes durch eine, der ersten Öffnung gegenüberliegende zweite Öffnung entladen. Zweckmäßige Ausführungsformen der erfindungsgemäßen Vorrichtung umfassen eine oder mehrere stationäre oder verfahrbare Schleusenkammern und eine oder mehrere stationäre oder verfahrbare Abschreckkammern, welche auf gegenüberliegenden Seiten der Niederdruck-Heizkammern angeordnet bzw. verfahrbar sind. In einer derartigen Vorrichtung wird ein Chargenträger mit Werkstücken lediglich in einer Raumrichtung bewegt, d.h. von einer Schleusenkammer durch eine erste Öffnung in eine Niederdruck-Heizkammer geladen und nach Beendigung eines Aufstick-, Aufkohl- oder Diffusions-Schrittes von der Niederdruck-Heizkammer durch ein zweite Öffnung in eine Abschreckkammer durchgereicht. In einer derartig konfigurierten Vorrichtung mit unidirektionalem Materialfluss sind die Vorgänge des Ladens und Entladens der Niederdruck-Heizkammern voneinander entkoppelt und können praktisch unabhängig voneinander hinsichtlich der Produktivität bzw. des Durchsatzes des erfindungsgemäßen Verfahrens optimiert werden.

Die Niederdruck-Heizkammern umfassen zweckmäßig eine äußere und innere Kammerwandung bzw. -wände sowie eine zwischen der äußeren und inneren Kammerwandung angeordnete thermische Isolierung. Die äußere Kammerwandung besteht aus einem metallischen Werkstoff, insbesondere aus Stahlblech und ist gegebenenfalls mit einer Wasserkühlung ausgerüstet. Die innere Kammerwandung ist aus einem thermisch widerstandsfähigen Material, wie Grafit oder Carbonfaser-verstärktem Grafit (CFC) gefertigt. Die thermische Isolierung besteht vorzugsweise aus Grafitfilz. Jede Niederdruck-Heizkammer ist mit einem oder mehreren Heizelementen ausgerüstet, die vorzugsweise aus Grafit oder aus Carbonfaser-verstärktem Grafit (CFC) bestehen und elektrisch betrieben werden. Die Heizelemente sind vorzugsweise in einem oberen Bereich der Niederdruck-Heizkammer nahe den Wänden der inneren Kammer angeordnet.

Gegebenenfalls sind die Niederdruck-Heizkammern mit Stellgliedern, wie beispielsweise elektrischen Linearantrieben, eines modularen Chargentransportsystems ausgerüstet. Um eine Überhitzung der Stellglieder durch die thermische Strahlung in der Niederdruck-Heizkammer zu vermeiden, sind die Stellglieder innerhalb einer thermischen, vorzugsweise wassergekühlten Abschirmung in einem unteren Bereich der Niederdruck-Heizkammer angeordnet. Nach Beladung einer Niederdruck-Heizkammer mit einem plattenförmig ausgebildeten Chargenträger mit Werkstücken fungiert der Chargenträger als zusätzliche Abschirmung. In einer vorteilhaften Weiterbildung der erfindungsgemäßen Vorrichtung sind die Antriebe des Chargentransportsystems außerhalb der Niederdruck-Heizkammern angeordnet und über Wellen und Vakuumdurchführungen mit mechanischen Stellgliedern in den Niederdruck-Heizkammern gekoppelt.

Mindestens eine der Niederdruck-Heizkammern ist für das Aufsticken vorgesehen und mit einer elektrischen Energieversorgung verbunden. Die elektrische Energieversorgung umfasst eine Gleichspannungsquelle, deren Pluspol mit einer elektrisch leitfähigen Innenwand der Niederdruck-Heizkammer oder mit einer innerhalb der Niederdruck-Heizkammer angeordneten Anode elektrisch verbunden ist. Vorzugsweise ist der Minuspol der Gleichspannungsquelle elektrisch mit einem für den Chargenträger vorgesehenen elektrischen Kontakt, mit einer innerhalb der Niederdruck-Heizkammer angeordneten Aktivgitterelektrode oder mit einem Spannungsteiler mit zwei Klemmen verbunden, an welche die Aktivgitterelektrode und der elektrische Kontakt für den Chargenträger derart angeschlossen sind, dass bei eingeschalteter Gleichspannungsquelle der Chargenträger und die Werkstücke gegenüber der Aktivgitterelektrode ein negatives Potential annehmen.

Die elektrische Energieversorgung ist eingerichtet für den Betrieb mit einer Gleichspannung von 200 bis 1000 V, einem Gleichstrom von 10 bis 200 A und einer kontinuierlichen Leistung von 2 bis 200 kVA. Vorzugsweise ist die elektrische Energieversorgung für die Erzeugung einer gepulsten Gleichspannung mit variabel einstellbarer Pulsfrequenz im Bereich von einigen 100 Hertz bis zu 1 Megahertz, insbesondere von 200 Hertz bis 5 Kilohertz, sowie variabel einstellbarem Tastverhältnis (tv) im Bereich von 1,0 bis 0,001 ausgelegt. Das Tastverhältnis (tv) bezeichnet das Verhältnis von Pulsdauer (tp) zur Periode, d.h. zu der Summe aus Pulsdauer (tp) und der Totzeit (to), in der die Gleichspannung abgeschaltet ist, gemäß der Beziehung tv = tp / (tp+to). Die Pulsdauer (tp) ist vorzugsweise kleiner/gleich 100 µs, während die Totzeit vorzugsweise größer/gleich 100 µs ist. In einer besonders bevorzugten Ausführungsform umfasst die elektrische Energieversorgung zudem einen Zündimpuls-Generator, der am Anfang eines regulären Pulses einen Zündimpuls mit einer hohen Spitzenleistung von einigen Megawatt und einer kurzen Dauer von wenigen Mikrosekunden erzeugt. Derartige Zündimpulse unterstützen die Ausbildung von gepulsten Entladungsplasmen in einer Niederdruck-Heizkammer. Elektrische Energieversorgungen der vorstehenden Art sind bekannt und werden kommerziell angeboten. Typischerweise umfassen derartige elektrische Energieversorgungen eine Mikrocontroller-basierte elektronische Steuerung, Speicherkondensatoren und schnelle Hochleistungsschalter, vorzugsweise IGBTs (insulated-gate bipolar transistor). Zweckmäßig umfasst die elektrische Energieversorgung zudem eine Schutzschaltung, welche anhand der am Entladungsplasma abfallenden Spannung und der Stromstärke einen Lichtbogen erkennt und die Leistungszufuhr für eine kurze Zeit, die typischerweise 100 Mikrosekunden bis zu 1 Millisekunde beträgt, abschaltet.

Vorzugsweise umfassen eine oder mehrere der für das Aufsticken vorgesehenen Niederdruck-Heizkammern eine Aktivgitterelektrode, die aus einem elektrisch leitfähigen und gegenüber Temperaturen bis zu 1200 °C beständigen Werkstoff, insbesondere aus einem Metall, einer Metalllegierung, Grafit oder Carbonfaser-verstärktem Grafit (CFC) gefertigt ist. Die Aktivgitterelektrode ist derart ausgebildet, dass sie in Betriebsstellung den Chargenträger mit den Werkstücken weitgehend oder vollständig umschließt. In Betriebsstellung hat die Aktivgitterelektrode beispielsweise die Form einer Kugelschale, einer Halbkugelschale, einer Teiloberfläche oder der gesamten Oberfläche eines Quaders. Vorzugsweise ist die Aktivgitterelektrode tunnelartig gestaltet und hat eine rechteckige oder halbkreisförmige Kontur mit zwei einander gegenüberliegenden Seitengittern und einem die Seitengitter verbindenden Deckengitter.

In einer weiteren Ausführungsform der erfindungsgemäßen Vorrichtung sind die für das Aufsticken vorgesehenen Niederdruck-Heizkammern eingerichtet für Plasma-Immersion-Ionen-Implantation. Hierfür sind die Aufstick-Heizkammern mit einem elektrischen Pulsgenerator verbunden, mit dem negative Spannungspulse mit einer Amplitude von 1 bis 300 KV und variabler Pulsdauer an die Werkstücke angelegt werden können. Zudem sind die Aufstick-Heizkammern mit einem Plasmagenerator verbunden. Der Plasmagenerator wird mit Frequenzen im Bereich von 10 bis 100 MHz (Radiofrequenz) oder von etwa 1 bis 4 GHz (Mikrowellen) betrieben. Die zur Erzeugung des Plasmas erforderliche Energie wird kapazitiv, induktiv oder über einen Wellenleiter in das Gas in der Aufstick-Heizkammer eingekoppelt. Im Stand der Technik sind verschiedene Vorrichtungen für Plasma-Immersion-Ionen-Implantation bekannt.

Die Erfindung wird nachfolgend anhand von Figuren zusätzlich erläutert. Es zeigt
- Fig. 1: eine Vorrichtung mit einer zentral angeordneten Transferkammer;
- Fig. 2: eine Vorrichtung mit vertikal übereinander angeordneten Niederdruck-Heizkammern, einer Transferkammer und einer stationären bifunktionalen Schleusen-Abschreck-Kammer;
- Fig. 3: eine Vorrichtung mit horizontal nebeneinander angeordneten Niederdruck-Heizkammern und jeweils einer horizontal verfahrbaren Schleusen- und Abschreckkammer;
- Fig. 4: eine Vorrichtung mit paarweise verbundenen Niederdruck-Heizkammern und jeweils einer vertikal verfahrbaren Schleusen- und Abschreckkammer;
- Fig. 5: eine Schnittansicht einer Niederdruck-Heizkammer für das Aufsticken; und
- Fig. 6: eine perspektivische Ansicht einer Aktivgitterelektrode.

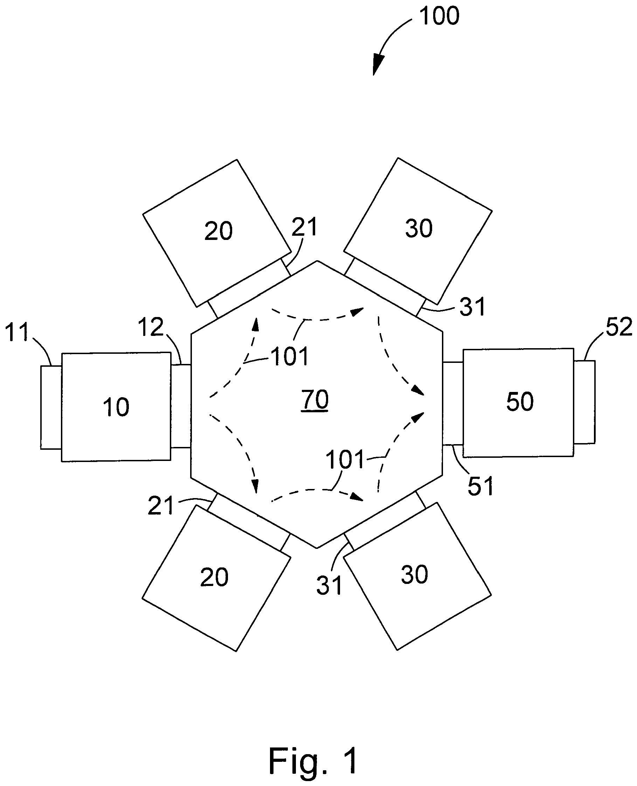

Fig. 1 zeigt eine Draufsicht einer ersten erfindungsgemäßen Vorrichtung 100 mit einer zentral angeordneten Transferkammer, einer Schleusenkammer 10, zwei Niederdruck-Heizkammern 20 für das Aufkohlen und gegebenenfalls Diffundieren, zwei Niederdruck-Heizkammern 30 für das Aufsticken sowie einer Abschreckkammer 50. Jede der Kammern 10, 20, 30 und 50 ist mit der Transferkammer 70 fest verbunden. Der Innenraum der Kammern 10, 20, 30 und 50 ist über Vakuumschieber oder Vakuumtüren 12, 21, 31, respektive 51 von dem Innenraum der Transferkammer 70 gasdicht trennbar. Auf einer der Transferkammer 70 gegenüberliegenden Seite sind die Schleusenkammer 10 und die Abschreckkammer 50 jeweils mit einem Vakuumschieber oder einer Vakuumtür 11, respektive 52 ausgerüstet. Bei geöffnetem Vakuumschieber oder geöffneter Vakuumtür 11 und geschlossenem Vakuumschieber oder geschlossener Vakuumtür 12 wird in die Schleusenkammer 10 ein Chargenträger mit Werkstücken geladen, ohne hierbei ein Vakuum in der Transferkammer 70 mit einem Druck von kleiner 300 mbar, kleiner 200 mbar, kleiner 100 mbar und insbesondere kleiner 50 mbar zu beeinträchtigen. Nachdem der Chargenträger mit den Werkstücken in die Schleusenkammer 10 geladen ist, wird der Vakuumschieber oder die Vakuumtür 11 geschlossen und die Schleusenkammer 10 auf einen Druck von kleiner 300 mbar, kleiner 200 mbar, kleiner 100 mbar und insbesondere kleiner 50 mbar evakuiert. Sodann wird der Vakuumschieber oder die Vakuumtür 12 geöffnet und der Chargenträger mit den Werkstücken mithilfe eines Chargentransportsystems in die Transferkammer 70 übergeben. Hieran anschließend wird der Chargenträger mit den Werkstücken zum Aufkohlen oder Aufsticken von der Transferkammer 70 in eine der Niederdruck-Heizkammern 20 oder 30 geladen. Vorzugsweise sind die Vakuumschieber oder Vakuumtüren 21 und 31 lediglich während des Ladens und Entladens von der Transferkammer 70 in die jeweilige Niederdruck-Heizkammer 20 oder 30 und vice versa geöffnet und im Übrigen geschlossen, um Kontamination und Wärmeverluste der Niederdruck-Heizkammern 20, 30 sowie thermische Belastung der Transferkammer 70 aufgrund von Wärmestrahlung aus den Niederdruck-Heizkammern 20, 30 zu minimieren. Nach Ausführung von jeweils einem oder mehreren Aufkohl- und Aufstick-Schritten sowie gebebenenfalls Diffusions-Schritten wird der Chargenträger mit den Werkstücken bei geöffnetem Vakuumschieber oder geöffneter Vakuumtür 51 in die zuvor auf einen Druck von kleiner 300 mbar, kleiner 200 mbar, kleiner 100 mbar und insbesondere kleiner 50 mbar evakuierte Abschreckkammer 50 übergeben. Der Vakuumschieber oder die Vakuumtür 51 wird geschlossen und die Werkstücke mit einem Fluid, wie beispielsweise gefilterter und auf einen Druck von bis zu 20 bar verdichteter Raumluft abgeschreckt. Im Weiteren sind zur Abschreckung Fluide, wie auf einen Druck von bis zu 20 bar verdichteter Stickstoff, Helium oder Öl vorgesehen. Um den Chargenträger mit den Werkstücken aus der Vorrichtung 100 zu entnehmen, wird bei geschlossenem Vakuumschieber oder geschlossener Vakuumtür 51 der Vakuumschieber oder die Vakuumtür 52 geöffnet, ohne hierbei das Vakuum in der Transferkammer 70 zu beeinträchtigen.
Der Materialfluss bzw. die Bewegung des Chargenträgers mit den Werkstücken ist in Fig. 1 mittels Bewegungspfeilen 101 angedeutet.
In einer alternativen, in den Figuren nicht gezeigten Ausführungform der erfindungsgemäßen Vorrichtung 100 ist die Kammer 10 als bifunktionale Schleusen-Abschreck-Kammer und die Kammer 50 als Niederdruck-Heizkammer für das Aufkohlen, Aufsticken oder gegebenfalls Diffundieren ausgebildet. In einer derartig konfigurierten Vorrichtung werden die Werkstücke über die Schleusen-Abschreck-Kammer in die Vorrichtung geladen sowie entladen.

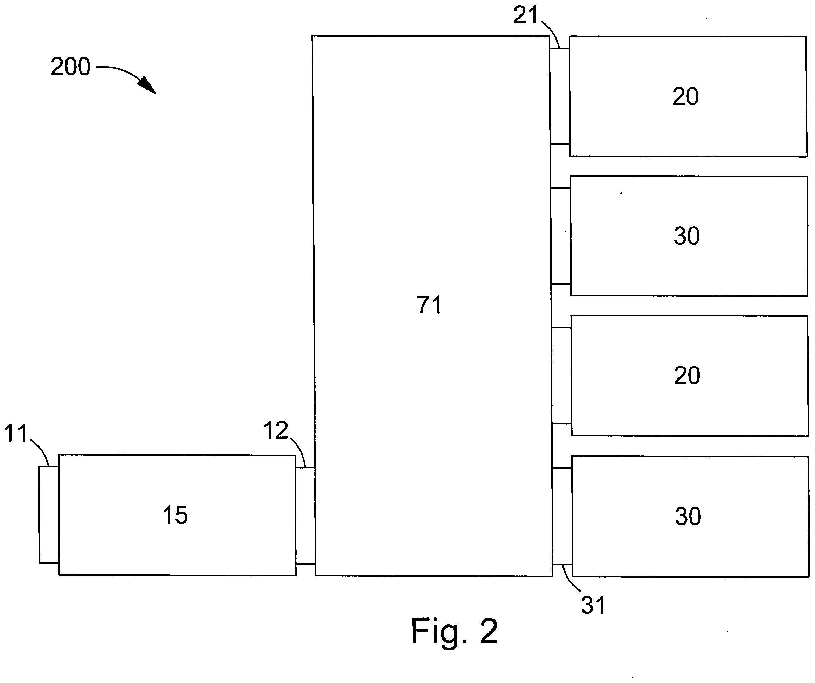

Fig. 2 zeigt eine schematische Seitenansicht einer weiteren erfindungsgemäßen Vorrichtung 200 mit jeweils zwei (insgesamt vier) vertikal übereinander angeordneten Niederdruck-Heizkammern 20 und 30 für das Aufkohlen und gegebenfalls Diffundieren, respektive für das Aufsticken, die an eine Transferkammer 71 angeschlossen sind und deren Innenraum jeweils vermittels eines Vakuumschiebers oder einer Vakuumtür 21, respektive 31 von dem Innenraum der Transferkammer 71 gasdicht trennbar ist. Im Weiteren umfasst die Vorrichtung eine ebenfalls an die Transferkammer 71 angeschlossene bifunktionale Schleusen-Abschreck-Kammer 15 mit zwei an gegenüberliegenden Stirnseiten angeordneten Vakuumschiebern oder Vakuumtüren 11 und 12. Der Innenraum der bifunktionalen Schleusen-Abschreck-Kammer 15 kann vermittels des Vakuumschiebers oder der Vakuumtür 12 von dem Innenraum der Transferkammer 71 gasdicht getrennt werden.
In der Transferkammer 71 ist ein, in Fig. 2 nicht gezeigtes Chargentransfersystem angeordnet, das einen vertikal verfahrbaren Aufzug umfasst, auf dem ein Teleskopmechanismus montiert ist. Der Teleskomechanismus ist eingerichtet für die Aufnahme und horizontale Verfahrung eines Chargenträgers und/oder Chargengestells mit Werkstücken. Mittels des Chargentransportsystems können Chargenträger und/oder Chargengestelle mit Werkstücken von der bifunktionalen Schleusen-Abschreck-Kammer 15 wahlweise in eine der Niederdruck-Heizkammern 20, 30 übergeben werden. Zudem werden je nach Prozessvorgabe Chargenträger und/oder Chargengestelle mit Werkstücken von einer der Niederdruck-Heizkammern 20, 30 in eine andere Niederdruck-Heizkammer 20, 30 transferiert.

Um einen Chargenträger und/oder ein Chargengestell mit Werkstücken in die Vorrichtung 200 zu laden, wird dieses bei geschlossenem Vakuumschieber oder geschlossener Vakuumtür 12 und geöffnetem Vakuumschieber oder geöffneter Vakuumtür 11 in der bifunktionalen Schleusen-Abschreck-Kammer 15 abgelegt. Der Vakuumschieber oder die Vakuumtür 11 wird geschlossen und der Innenraum der bifunktionalen Schleusen-Abschreck-Kammer 15 mittels Pumpen evakuiert. Die nachfolgenden Verfahrensschritte des Aufkohlens, gegebenenfalls Diffundieren und des Aufstickens werden analog zu der vorstehend in Zusammenhang mit der Vorrichtung 100 und Fig. 1 beschriebenen Weise ausgeführt. Zum Abschrecken und Entladen eines Chargenträgers und/oder eines Chargengestell mit Werkstücken wird dieses von einer der Niederdruck-Heizkammern 20, 30 in die bifunktionale Schleusen-Abschreck-Kammer 15 transferiert.

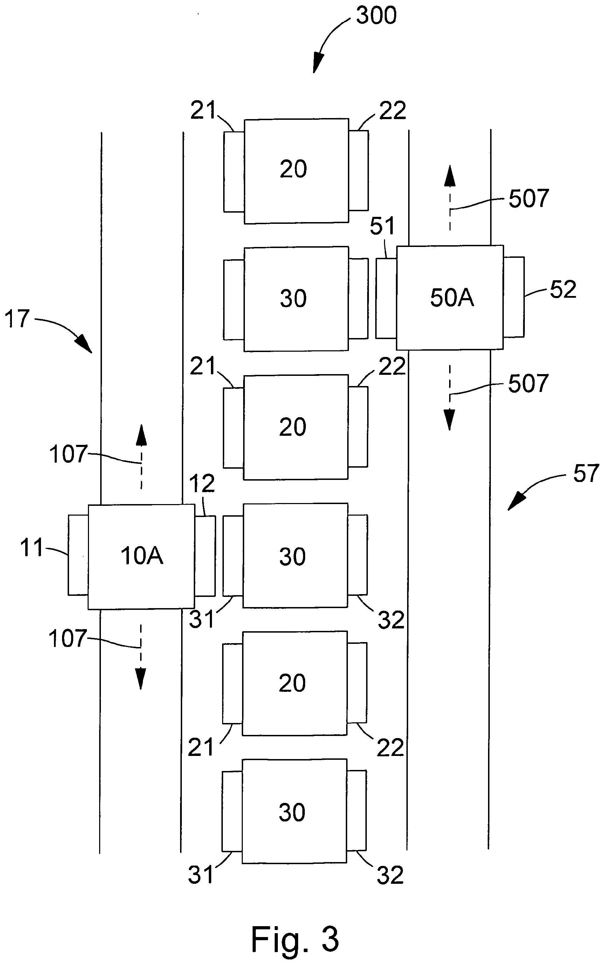

Fig. 3 zeigt eine Draufsicht einer weiteren erfindungsgemäßen Vorrichtung 300 mit jeweils drei horizontal nebeneinander angeordneten Niederdruck-Heizkammern 20 und 30 für das Aufkohlen und gegebenfalls Diffundieren, respektive für das Aufsticken. Jede der Niededruck-Heizkammern 20 und 30 ist an einer ersten Stirnseite mit einem ersten Vakuumschieber oder einer ersten Vakuumtür 21, respektive 31 und an einer zweiten gegenüberliegenden Stirnseite mit einem zweiten Vakuumschieber oder einer zweiten Vakuumtür 22, respektive 32 ausgerüstet. Im Weiteren umfasst die Vorrichtung 300 eine, entlang der ersten Stirnseiten der Niederdruck-Heizkammern 20, 30 horizontal verfahrbare Schleusenkammer 10A sowie eine, entlang der zweiten Stirnseiten der Niederdruck-Heizkammern 20, 30 horizontal verfahrbare Abschreckkammer 50A. Für das Verfahren der Schleusenkammer 10A und der Abschreckkammer 50A sind Linearführungen 17, respektive 57, die beispielsweise schienenartig ausgebildet sind, sowie in Fig. 3 nicht gezeigte Antriebe vorgesehen.
Die Bewegung der Schleusenkammer 10A und der Abschreckkammer 50A ist in Fig. 3 durch Bewegungspfeile 107, respektive 507 angedeutet. Die Schleusenkammer 10A und die Abschreckkammer 50A sind an einer ersten Stirnseite mit einem ersten Vakuumschieber oder einer ersten Vakuumtür 11, respektive 51 und an einer zweiten gegenüberliegenden Stirnseite mit einem zweiten Vakuumschieber oder einer zweiten Vakuumtür 12, respektive 52 ausgerüstet. Bei geöffnetem ersten Vakuumschieber oder geöffneter Vakuumtür 11 wird ein Chargenträger mit Werkstücken in die Schleusenkammer 10A geladen. Die Vakuumschieber oder Vakuumtüren 11 und 12 werden geschlossen und die Schleusenkammer 10A auf einen Druck von kleiner 300 mbar, kleiner 200 mbar, kleiner 100 mbar und insbesondere kleiner 50 mbar evakuiert und zum Aufkohlen oder Aufsticken vor einer nicht mit Werkstücken belegten Niederdruck-Heizkammer 20 positioniert und gasdicht an diese gedockt. Der Vakuumschieber oder die Vakuumtür 12 der Schleusenkammer 10A und der Vakuumschieber oder die Vakuumtür 21 oder 31 der angedockten Niederdruck-Heizkammer 20, respektive 30 werden geöffnet und der Chargenträger mit den Werkstücken mittels eines Chargentransportsystems von der Schleusenkammer 10A in die angedockte Niederdruck-Heizkammer 20, respektive 30 transferiert. Der Vakuumschieber oder die Vakuumtür 21, respektive 31 wird geschlossen und die Werkstücke in vorgegebener Reihenfolge einem oder mehreren Aufkohl-Schritten, gegebenfalls einem oder mehreren Diffusions-Schritten und einem oder mehreren Aufstick-Schritten unterzogen. Beispielsweise werden die Werkstücke zunächst in einer Niederdruck-Heizkammer 20 aufgekohlt und gegebenenfalls diffundiert, hieran anschließend mittels der Schleusenkammer 10A in eine Niederdruck-Heizkammer 30 transferiert und darin aufgestickt. Nach Ausführung der vorgebebenen Aufhohl-, Diffusions- und Aufstick-Schritte, werden die Werkstücke in der Abschreckkammer 50A mittels eines Fluids, wie beispielsweise gefilterter und auf einen Druck von bis zu 20 bar verdichteter Raumluft abgeschreckt. Hierzu wird die Abschreckkammer 50A vor der betreffenden Niederdruck-Heizkammer 20 oder 30 positioniert und gasdicht an diese gedockt. Anschließend werden der Vakuumschieber oder die Vakuumtür 22 oder 32 der Niederdruck-Heizkammer 20 oder 30 und der Vakuumschieber oder die Vakuumtür 51 der Abschreck-kammer 50A geöffnet und der Chargenträger mit den Werkstücken von der Niederdruck-Heizkammer 20 oder 30 in die Abschreckkammer 50A übergeben. Der Vakuumschieber oder die Vakuumtür 51 wird geschlossen und der Abschreck-Schritt ausgeführt. Schließlich wird der Vakuumschieber oder die Vakuumtür 52 geöffnet und der Chargenträger mit den Werkstücken aus der Vorrichtung 300 entnommen.
In einer alternativen, in den Figuren nicht gezeigten Ausführungform der erfindungsgemäßen Vorrichtung 300 ist die Kammer 10A als bifunktionale, verfahrbare Schleusen-Abschreck-Kammer ausgebildet, wobei die Abschreckkammer 50A entfällt. In einer derartig konfigurierten Vorrichtung werden die Werkstücke über die Schleusen-Abschreck-Kammer in die Vorrichtung geladen sowie entladen.

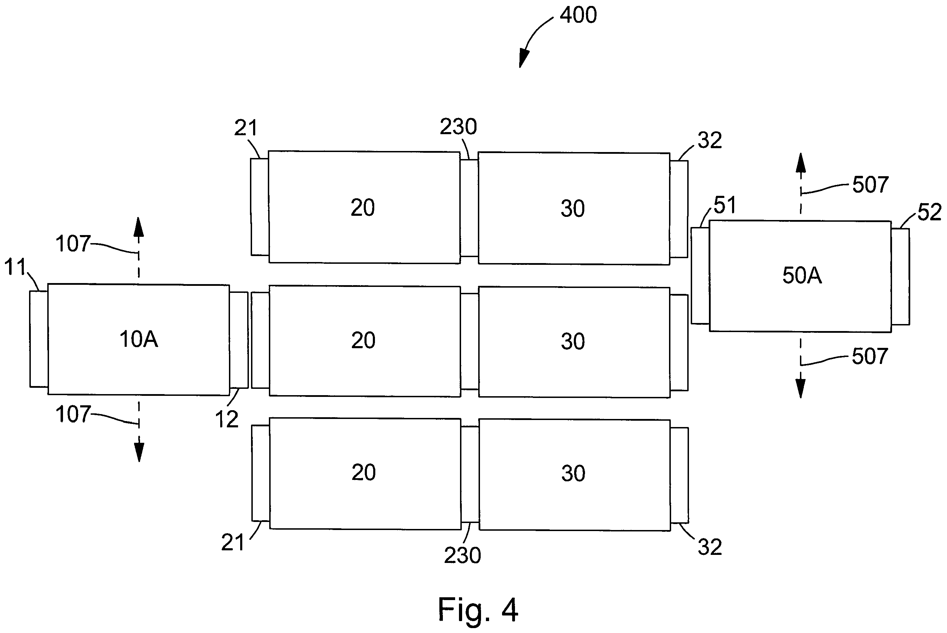

Fig. 4 zeigt eine seitliche Schnittansicht einer weiteren erfindungsgemäßen Vorrichtung 400 mit paarweise, horizontal nebeneinander angeordneten und miteinander verbundenen Niederdruck-Heizkammern 20 und 30. Zwei, drei, vier oder mehr Paare mit je einer Niederdruck-Heizkammer 20 und einer Niederdruck-Heizkammer 30 sind vertikal übereinander angeordnet. Alternativ hierzu ist im Rahmen der Erfindung eine Konfiguration vorgesehenen, bei der die Paare mit je einer Niederdruck-Heizkammer 20 und einer Niederdruck-Heizkammer 30 horizontal nebeneinander angeordnet sind. Zwischen den Niederdruck-Heizkammern 20 und 30 eines Paares ist ein Vakuumschieber oder eine Vakuumtür 230 angeordnet, welche den Innenraum der Niederdruck-Heizkammern 20 und 30 voneinander trennt und lediglich für den Transfer von Werkstücken geöffnet wird. Jede der Niederdruck-Heizkammern 20 ist an einer dem Vakuumschieber oder der Vakuumtür 230 gegenüberliegenden Stirnseite mit einem Vakuumschieber oder einer Vakuumtür 21 ausgerüstet. In analoger Weise ist jede der Niederdruck-Heizkammern 30 an einer dem Vakuumschieber oder der Vakuumtür 230 gegenüberliegenden Stirnseite mit einem Vakuumschieber oder einer Vakuumtür 32 ausgerüstet.
Im Weiteren umfasst die Vorrichtung 400 eine vertikal - oder gegebenenfalls horizontal - verfahrbare Schleusenkammer 10A, die vor jeder der Niederdruck-Heizkammern 20 positionierbar ist, sowie eine vertikal - oder gegebenenfalls horizontal - verfahrbare Abschreckkammer 50A, die vor jeder der Niederdruck-Heizkammern 30 positionierbar ist. Die Schleusenkammer 10A ist an zwei gegenüberliegenden Stirnseiten mit Vakuumschiebern oder Vakuumtüren 11 und 12 ausgerüstet. Die Abschreckkammer 50A ist ebenfalls an zwei gegenüberliegenden Stirnseiten mit Vakuumschiebern oder Vakuumtüren 51 und 52 ausgerüstet. Der vertikale - oder gegebenenfalls horizontale - Verfahrweg der Schleusenkammer 10 und der Abschreckkammer 50A ist durch Bewegungspfeile 107, respektive 507 angedeutet. Für das Verfahren der Schleusenkammer 10A und der Abschreckkammer 50A sind in Fig. 4 nicht gezeigte Linearführungen, die beispielsweise schienenartig ausgebildet sind, sowie Antriebe vorgesehen.
Die Vorrichtung 400 wird in analoger Weise betrieben, wie vorstehend im Zusammenhang mit der Vorrichtung 300 und Fig. 3 beschrieben, und unterscheidet sich lediglich dadurch, dass der Transfer von Werkstücken von einer Niederdruck-Heizkammer 20 in eine Niederdruck-Heizkammer 30 direkt erfolgt, ohne dass hierfür eine verfahrbare Schleusenkammer 20 benötigt wird.

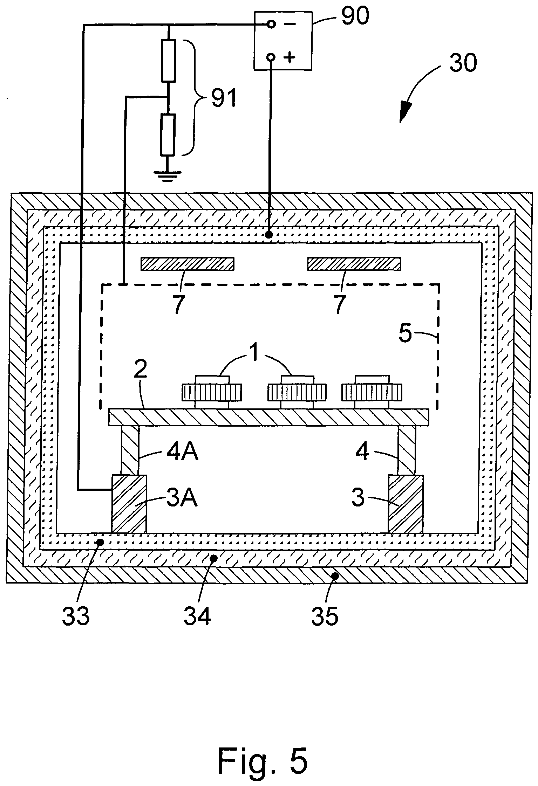

Fig. 5 zeigt eine schematische Schnittansicht einer für das Aufsticken vorgesehenen Niederdruck-Heizkammer 30 mit einer inneren Kammerwand 33, einer äußeren Kammerwand 35, und einer zwischen der inneren und äußeren Kammerwand 33 und 35 angeordneten thermischen Isolierung 34 sowie einem oder mehreren Heizelementen 7. Die äußere Kammerwand 35 ist vorzugsweise aus einem metallischen Werkstoff, insbesondere aus Stahl gefertigt und optional mit einer, in Fig. 5 nicht gezeigten Wasserkühlung ausgerüstet. Die thermische Isolierung 34 besteht bevorzugt aus Grafitfilz. Die innere Kammerwand 33 und die Heizelemente 7 sind vorzugsweise aus Grafit oder Carbonfaser-verstärktem Grafit (CFC) gefertigt. Vorzugsweise ist die Niederdruck-Heizkammer 30 mit Auflagen 3, 3A für einen Chargenträger ausgerüstet, wobei mindestens eine Auflage 3A einen elektrischen Kontakt aufweist oder aus einem elektrisch leitfähigen Werkstoff, wie einem Metall, einer Metalllegierung, Grafit oder Carbonfaser-verstärktem Grafit (CFC) gefertigt ist.
Im Weiteren sind in Fig. 5 ein Chargenträger 2 mit zu behandelnden Werkstücken 1 und eine optionale Aktivgitterelektrode 5 gezeigt. Der Chargenträger 2 ist vorzugsweise platten- oder gitterförmig ausgebildet und an einer unteren Seite mit Stellfüßen 4, 4A ausgerüstet, wobei mindestens einer der Stellfüße 4A elektrisch leitfähig ist.
Die Auflagen 3, 3A und die Stellfüße 4, 4A sind passend zueinander angeordnet, so dass durch die Auflage 3A und den Stellfuß 4A ein elektrisch leitfähiger Kontakt gebildet wird.
Die innere Kammerwand 33 ist über elektrische Kabel mit dem Pluspol einer elektrischen Energieversorgung 90 verbunden. Die elektrische Energieversorgung 90 ist vorzugsweise als pulsbare Gleichspannungsquelle ausgelegt und für den Betrieb eines Entladungsplasmas mit einer Gleichspannung von 200 bis 1000 V, einem Gleichstrom von 10 bis 200 A und einer kontinuierlichen Leistung von 2 bis 200 kVA eingerichtet. In einer besonders zweckmäßigen Ausführungsform der Erfindung umfasst die elektrische Energieversorgung 90 einen Zündimpulsgenerator.
Die für die Niederdruck-Heizkammer verwendeten elektrischen Kabel sind teilweise aus einem thermisch beständigen Werkstoff, wie Wolfram oder Grafit gefertigt. Alternativ hierzu werden Kupferkabel mit einer thermischen Abschirmung aus einem keramischen Werkstoff verwendet.
Der Chargenträger 2 bzw. die Auflage 3A und/oder eine optionale Aktivgitterelektrode 5 sind über elektrische Kabel an den Minuspol der elektrischen Energieversorgung 90 angeschlossen und bezogen auf die innere Kammerwand 33 als Kathode geschaltet.
Bei Verwendung einer Aktivgitterelektrode 5 kann es vorteilhaft sein, die Werkstücke 1 gegenüber der Aktivgitterelektrode 5 auf ein negatives Potential (sogenannte Biasspannung) zu legen. Dementsprechend ist ein optionaler Spannungsteiler 91 mit zwei Ausgängen bzw. Klemmen für die Werkstücke 1 und das Aktivgitter 5 vorgesehen.

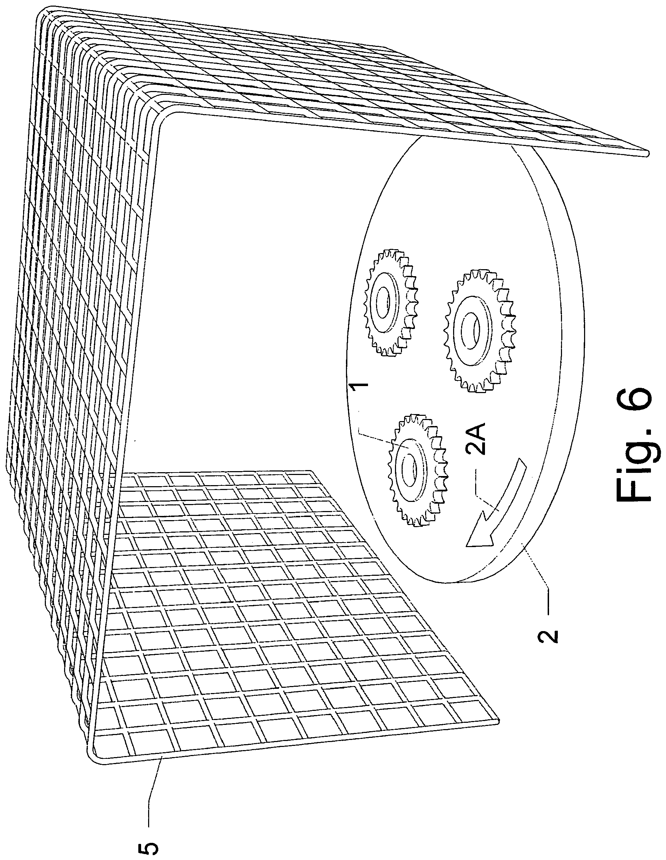

Fig. 6 zeigt eine perspektivische Ansicht einer zweckmäßig gestalteten Aktivgitterelektrode 5 sowie eines Chargenträgers 2 mit Werkstücken 1. Die Aktivgitterelektrode 5 ist tunnelartig ausgebildet mit zwei einander gegenüberliegenden Seitenteilen und einem die beiden Seitenteile verbindenden Deckenteil.
Gegebenenfalls ist der Chargenträger 2 mit einem, in Fig. 6 nicht gezeigten Drehantrieb gekoppelt. Der Drehantrieb ermöglicht es, den Chargenträger 2 während des Aufstickens kontinuierlich zu drehen, um eine möglichst homogene Beaufschlagung der Werkstücke 1 mit dem Entladungsplasma zu gewährleisten. Die Rotation des Chargenträgers 2 ist in Fig. 6 durch den Bewegungspfeil 2A angedeutet.

### Bezugszeichenliste

- 1: Werkstücke
- 2: Chargenträger
- 2A: Bewegungspfeil
- 3, 3A: Auflage für Chargenträger
- 4, 4A: Stellfüße des Chargenträgers
- 5: Aktivgitterelektrode
- 10: stationäre Schleusenkammer
- 10A: verfahrbare Schleusenkammer
- 15: Schleusen-Abschreck-Kammer
- 17: Verfahreinrichtung
- 20: Niederdruck-Heizkammer für Aufkohlung
- 30: Niederdruck-Heizkammer für Aufstickung
- 33: innere Wand einer Niederdruck-Heizkammer
- 34: thermische Isolierung einer Niederdruck-Heizkammer
- 35: äußere Wand einer Niederdruck-Heizkammer
- 50: stationäre Abschreckkammer
- 50A: verfahrbare Abschreckkammer
- 57: Verfahreinrichtung
- 70: Transferkammer (horizontal)
- 71: Transferkammer (vertikal)
- 90: elektrische Energieversorgung
- 11, 12, 21, 22, 31, 32, 51, 52, 230: Vakuumschieber oder Vakuumtüren
- 90: elektrische Energieversorgung
- 100: Vorrichtung für thermochemisches Härten
- 200: Vorrichtung für thermochemisches Härten
- 300: Vorrichtung für thermochemisches Härten
- 400: Vorrichtung für thermochemisches Härten
- 101: Bewegungspfeile
- 107: Bewegungspfeile
- 507: Bewegungspfeile

## Patentansprüche

1. Verfahren zum thermochemischen Härten von Werkstücken, umfassend in variabler Reihenfolge
- einen oder mehrere Aufkohl-Schritte, jeweils in einer kohlenstoffhaltigen Gasatmosphäre mit einem Druck von kleiner 50 mbar, wobei die Werkstücke auf Temperaturen von 900 bis 1050 °C gehalten werden;
- gegebenenfalls einen oder mehrere Diffusions-Schritte, jeweils in einer Gasatmosphäre mit einem Druck von kleiner 100 mbar; und
- einen oder mehrere Aufstick-Schritte, jeweils in einer stickstoffhaltigen Gasatmosphäre mit einem Druck von kleiner 50 mbar, wobei die Werkstücke auf Temperaturen von 800 bis 1050 °C gehalten werden, die stickstoffhaltige Gasatmosphäre als Spendergas molekularen Stickstoff (N₂) enthält und mittels eines Entladungsplasmas angeregt wird; wobei
- das Verfahren derart geführt wird, dass Zeitintervalle zwischen zwei aufeinander folgenden Verfahrensschritten kürzer als 15 min sind und die Werkstücke während dieser Zeitintervalle in einer Gasatmosphäre mit einem Druck von kleiner 300 mbar gehalten werden.

2. Verfahren nach Anspruch 1, **dadurch gekennzeichnet, dass** die Zeitintervalle zwischen zwei aufeinander folgenden Verfahrensschritten kürzer als 10 min, vorzugsweise kürzer als 5 min und insbesondere kürzer als 1 min sind.

3. Verfahren nach Anspruch 1 oder 2, **dadurch gekennzeichnet, dass** die Werkstücke in einem Zeitintervall zwischen zwei aufeinander folgenden Verfahrensschritten in einer Gasatmosphäre mit einem Druck von kleiner 200 mbar, vorzugsweise kleiner 100 mbar gehalten werden.

4. Verfahren nach einem oder mehreren der Ansprüche 1 bis 3, **dadurch gekennzeichnet, dass** die Temperatur der Werkstücke in einem Zeitintervall zwischen zwei aufeinander folgenden Verfahrensschritten größer 600 °C, vorzugsweise größer 700 °C und insbesondere größer 800 °C ist.

5. Verfahren nach einem oder mehreren der Ansprüche 1 bis 4, **dadurch gekennzeichnet, dass** das Verfahren in sequentieller Folge die Schritte
- Aufkohlen / Aufsticken;
- Aufkohlen / Diffundieren / Aufsticken;
- Aufsticken / Aufkohlen / Aufsticken;
- Aufsticken / Aufkohlen / Aufsticken / Aufkohlen; oder
- Aufsticken / Aufkohlen / Diffundieren / Aufsticken
umfasst.

6. Verfahren nach einem oder mehreren der Ansprüche 1 bis 5, **dadurch gekennzeichnet, dass** das Entladungsplasma mit einer gegebenenfalls gepulsten Gleichspannung von 200 bis 1000 V, einem Gleichstrom von 10 bis 200 A und einer kontinuierlichen Leistung von 2 bis 200 kVA betrieben wird und/oder bei Anregung der stickstoffhaltigen Gasatmosphäre mittels eines gepulsten Gleichstrom-Entladungsplasmas in einem oder mehreren der Aufstick-Schritte bevorzugt Zündimpulse eingesetzt werden.

7. Verfahren nach einem oder mehreren der Ansprüche 1 bis 6, **dadurch gekennzeichnet, dass** in einem oder mehreren der Aufstick-Schritte das Entladungsplasma mithilfe einer Aktivgitterelektrode erzeugt wird und die Werkstücke vorzugsweise auf einem relativ zur Aktivgitterelektrode negativen elektrischen Potential mit einem Betrag von 10 bis 400 Volt, insbesondere von 10 bis 200 V gehalten werden.

8. Verfahren nach einem oder mehreren der Ansprüche 1 bis 5, **dadurch gekennzeichnet, dass** in einem oder mehreren der Aufstick-Schritte Plasma-Immersion-Ionen-Implantation eingesetzt wird.

9. Verfahren nach einem oder mehreren der Ansprüche 1 bis 8, **dadurch gekennzeichnet, dass** die Werkstücke während der Aufstick-Schritte auf Temperaturen von 820 bis1000 °C, vorzugsweise 920 bis 980 °C gehalten werden und/oder die Werkstücke während der Aufkohl-Schritte auf Temperaturen von 940 bis 1050 °C gehalten werden.

10. Verfahren nach einem oder mehreren der Ansprüche 1 bis 9, **dadurch gekennzeichnet, dass** in den Aufstick-Schritten die stickstoffhaltige Gasatmosphäre aus N₂ und gegebenenfalls einem oder mehreren Trägergasen, wie H₂ und Argon besteht.

11. Verfahren nach einem oder mehreren der Ansprüche 1 bis 9, **dadurch gekennzeichnet, dass** in den Aufstick-Schritten die stickstoffhaltige Gasatmosphäre aus N₂ und einem oder mehreren kohlenstoffhaltigen Gasen, wie CO₂ oder CH₄ sowie gegebebenenfalls einem oder mehreren Trägergasen, wie H₂ und Argon besteht und der Anteil der kohlenstoffhaltigen Gase, bezogen auf N₂, vorzugsweise 2 bis 20 Vol.-%, besonders bevorzugt 4 bis 15 Vol-% und insbesondere 4 bis 10 Vol-% beträgt.

12. Verfahren nach einem oder mehreren der Ansprüche 1 bis 11, **dadurch gekennzeichnet, dass** in den Aufstick-Schritten der Druck der stickstoffhaltigen Gasatmosphäre kleiner 40 mbar, vorzugsweise kleiner 30 mbar und insbesondere kleiner 20 mbar ist.

13. Verfahren nach einem oder mehreren der Ansprüche 1 bis 12, **dadurch gekennzeichnet, dass** in den Aufkohl-Schritten die kohlenstoffhaltige Gasatmosphäre aus einem oder mehreren kohlenstoffhaltigen Spendergasen, wie C₂H₂, CO₂ und CH₄ und gegebenenfalls einem oder mehreren Trägergasen, wie H₂ und Argon besteht und der Druck der kohlenstoffhaltigen Gasatmosphäre vorzugsweise kleiner 40 mbar, besonders bevorzugt kleiner 30 mbar und insbesondere kleiner 20 mbar ist.

14. Verfahren nach einem oder mehreren der Ansprüche 1 bis 13, **dadurch gekennzeichnet, dass** das Verfahren einen Hochdruck-Diffusions-Schritt in einer N₂-Atmosphäre mit einem Druck von 0,9 bis 2 bar und vorzugsweise in sequentieller Folge die Schritte
- Aufsticken / Aufkohlen / Hochdruck-Diffundieren
umfasst.

15. Vorrichtung zum thermochemischen Härten von Werkstücken, umfassend
- m Niederdruck-Heizkammern mit m = 2, 3, 4, 5, 6, 7, 8, 9, oder 10;
- eine an die Niederdruck-Heizkammern angeschlossene Gasversorgung, die dafür eingerichtet ist, die Niederdruck-Heizkammern mit einem oder mehreren Gasen, gewählt aus der Gruppe umfassend N₂ , kohlenstoffhaltige Spendergase, wie C₂H₂, CO₂ und CH₄ und Trägergase, wie H₂ und Argon zu versorgen;
- eine Transferkammer, an die jede der Niederdruck-Heizkammern sowie eine Schleusenkammer und eine Abschreckkammer oder eine bifunktionale Schleusen-Abschreck-Kammer angebunden ist; oder
- eine Schleusenkammer und eine Abschreckkammer, die jeweils verfahrbar und mit jeder der Niederdruck-Heizkammern verbindbar sind; oder
- eine bifunktionale Schleusen-Abschreck-Kammer, die verfahrbar und mit jeder der Niederdruck-Heizkammern verbindbar ist;
**dadurch gekennzeichnet, dass**
eine oder mehrere der Niederdruck-Heizkammern mit einer elektrischen Energieversorgung verbunden und dafür eingerichtet sind, in einer stickstoffhaltigen Gasatmosphäre mit N₂ als Spendergas bei Temperaturen von über 800 °C und Drücken von kleiner 100 mbar ein Entladungsplasma mit einer Gleichspannung von 200 bis 1000 V, einem Gleichstrom von 10 bis 200 A und einer kontinuierlichen Leistung von 2 bis 200 kVA zu erzeugen.

16. Vorrichtung nach Anspruch 15, **dadurch gekennzeichnet, dass** die elektrische Energieversorgung für den Betrieb mit gepulster Gleichspannung, vorzugsweise in Verbindung mit Zündimpulsen eingerichtet ist.

17. Vorrichtung nach Anspruch 15 oder 16, **dadurch gekennzeichnet, dass** eine oder mehrere der Niederdruck-Heizkammern mit einer Aktivgitterelektrode ausgerüstet sind.

## Claims

1. Process for the thermochemical hardening of workpieces comprising, in a variable order:
- one or more carburization steps, in each case in a carbon-containing gas atmosphere having a pressure of less than 50 mbar, where the workpieces are maintained at temperatures of from 900 to 1050 °C;
- optionally one or more diffusion steps, in each case in a gas atmosphere having a pressure of less than 100 mbar; and
- one or more nitriding steps, in each case in a nitrogen-containing gas atmosphere having a pressure of less than 50 mbar, where the workpieces are maintained at temperatures of from 800 to 1050 °C, the nitrogen-containing gas atmosphere contains molecular nitrogen (N₂) as donor gas and is excited by means of a discharge plasma; wherein
- the process is carried out in such a way that time intervals between two successive process steps are shorter than 15 minutes and the workpieces are maintained in a gas atmosphere having a pressure of less than 300 mbar during these time intervals.

2. Process according to Claim 1, **characterized in that** the time intervals between two successive process steps are shorter than 10 minutes, preferably shorter than 5 minutes and in particular shorter than 1 minute.

3. Process according to Claim 1 or 2, **characterized in that** the workpieces are maintained in a gas atmosphere having a pressure of less than 200 mbar, preferably less than 100 mbar, during a time interval between two successive process steps.

4. Process according to one or more of Claims 1 to 3, **characterized in that** the temperature of the workpieces is greater than 600 °C, preferably greater than 700 °C and in particular greater than 800 °C, during a time interval between two successive process steps.

5. Process according to one or more of Claims 1 to 4, **characterized in that** the process comprises, in sequential order, the steps
- carburization/nitriding;
- carburization/diffusion/nitriding;
- nitriding/carburization/nitriding;
- nitriding/carburization/nitriding/ carburization; or
- nitriding/carburization/diffusion/nitriding.

6. Process according to one or more of Claims 1 to 5, **characterized in that** the discharge plasma is operated at an optionally pulsed DC voltage of from 200 to 1000 V, a direct current of from 10 to 200 A and a continuous power of from 2 to 200 kVA and/or ignition impulses are preferably used in one or more of the nitriding steps while the nitrogen-containing gas atmosphere is excited by means of a pulsed direct current discharge plasma.

7. Process according to one or more of Claims 1 to 6, **characterized in that** the discharge plasma is generated by means of an active grid electrode in one or more of the nitriding steps and the workpieces are preferably maintained at a negative electric potential relative to the active grid electrode having an absolute value of from 10 to 400 volt, preferably from 10 to 200 V.

8. Process according to one or more of Claims 1 to 5, **characterized in that** plasma immersion ion implantation is used in one or more of the nitriding steps.

9. Process according to one or more of Claims 1 to 8, **characterized in that** the workpieces are maintained at temperatures of from 820 to 1000 °C, preferably from 920 to 980 °C, during the nitriding steps and/or the workpieces are maintained at temperatures of from 940 to 1050 °C during the carburization steps.

10. Process according to one or more of Claims 1 to 9, **characterized in that** the nitrogen-containing gas atmosphere in the nitriding steps consists of N₂ and optionally one or more carrier gases such as H₂ and argon.

11. Process according to one or more of Claims 1 to 9, **characterized in that** the nitrogen-containing gas atmosphere in the nitriding steps consists of N₂ and one or more carbon-containing gases such as CO₂ or CH₄ and optionally one or more carrier gases such as H₂ and argon and the proportion of carbon-containing gases, based on N₂, is preferably from 2 to 20 % by volume, more preferably from 4 to 15 % by volume and in particular from 4 to 10 % by volume.

12. Process according to one or more of Claims 1 to 11, **characterized in that** the pressure of the nitrogen-containing gas atmosphere in the nitriding steps is less than 40 mbar, preferably less than 30 mbar and in particular less than 20 mbar.

13. Process according to one or more of Claims 1 to 12, **characterized in that** the carbon-containing gas atmosphere in the carburization steps consists of one or more carbon-containing donor gases such as C₂H₂, CO₂ and CH₄ and optionally one or more carrier gases such as H₂ and argon and the pressure of the carbon-containing gas atmosphere is preferably less than 40 mbar, more preferably less than 30 mbar and in particular less than 20 mbar.

14. Process according to one or more of Claims 1 to 13, **characterized in that** the process comprises a high-pressure diffusion step in an N₂ atmosphere having a pressure of from 0.9 to 2 bar and preferably, in sequential order, the steps
- nitriding/carburization/high-pressure diffusion.

15. Apparatus for the thermochemical hardening of workpieces, comprising
- m low-pressure heating chambers, where m = 2, 3, 4, 5, 6, 7, 8, 9 or 10;
- a gas supply connected to the low-pressure heating chambers which is configured for supplying the low-pressure heating chambers with one or more gases selected from the group consisting of N₂, carbon-containing donor gases such as C₂H₂, CO₂ and CH₄ and carrier gases such as H₂ and argon;
- a transfer chamber to which each of the low-pressure heating chambers and also a lock chamber and a quenching chamber or a bifunctional lock-quenching chamber are connected; or
- a lock chamber and a quenching chamber which are in each case movable and able to be connected to each of the low-pressure heating chambers; or
- a bifunctional lock-quenching chamber which is movable and can be connected to each of the low-pressure heating chambers;
**characterized in that**
one or more of the low-pressure heating chambers is/are connected to an electric energy supply and is/are configured for producing a discharge plasma at a DC voltage of from 200 to 1000 V, a direct current of from 10 to 200 A and a continuous power of from 2 to 200 kVA in a nitrogen-containing gas atmosphere comprising N₂ as donor gas at temperatures of above 800 °C and pressures of less than 100 mbar.

16. Apparatus according to Claim 15, **characterized in that** the electric energy supply is configured for operation with a pulsed DC voltage, preferably in combination with ignition impulses.

17. Apparatus according to Claim 15 or 16, **characterized in that** one or more of the low-pressure heating chambers is/are equipped with an active grid electrode.

## Revendications

1. Procédé de durcissement thermochimique de pièces, comprenant dans un ordre variable
- une ou plusieurs étapes de carburation, respectivement dans une atmosphère gazeuse contenant du carbone à une pression inférieure à 50 mbar, dans lequel les pièces sont maintenues à des températures de 900 à 1050 °C ;
- le cas échéant une ou plusieurs étapes de diffusion, respectivement dans une atmosphère gazeuse à une pression inférieure à 100 mbar ; et
- une ou plusieurs étapes de nitruration, respectivement dans une atmosphère gazeuse contenant de l'azote à une pression inférieure à 50 mbar, dans lequel les pièces sont maintenues à des températures de 800 à 1050 °C, l'atmosphère gazeuse contenant de l'azote contient de l'azote (N₂) moléculaire en tant que gaz distributeur et est excitée au moyen d'un plasma de décharge ; dans lequel
- le procédé est mené de sorte que des intervalles de temps entre deux étapes de procédé successives sont inférieurs à 15 min et les pièces sont maintenues pendant ces intervalles de temps dans une atmosphère gazeuse à une pression inférieure à 300 mbar.

2. Procédé selon la revendication 1, **caractérisé en ce que** les intervalles de temps entre deux étapes de procédé successives sont inférieurs à 10 min, de préférence inférieurs à 5 min et en particulier inférieurs à 1 min.

3. Procédé selon la revendication 1 ou 2, **caractérisé en ce que** les pièces sont maintenues dans un intervalle de temps entre deux étapes de procédé successives dans une atmosphère gazeuse à une pression inférieure à 200 mbar, de préférence inférieure à 100 mbar.

4. Procédé selon une ou plusieurs des revendications 1 à 3, **caractérisé en ce que** la température des pièces est dans un intervalle de temps entre deux étapes de procédé successives supérieure à 600 °C, de préférence supérieure à 700 °C et en particulier supérieure à 800 °C.

5. Procédé selon une ou plusieurs des revendications 1 à 4, **caractérisé en ce que** le procédé comprend dans l'ordre séquentiel les étapes de
- carburation/nitruration ;
- carburation/diffusion/nitruration ;
- nitruration/carburation/nitruration ;
- nitruration/carburation/nitruration/carburation ; ou
- nitruration/carburation/diffusion/nitruration.

6. Procédé selon une ou plusieurs des revendications 1 à 5, **caractérisé en ce que** le plasma de décharge est exploité avec une tension continue pulsée le cas échéant de 200 à 1000 V, un courant continu de 10 à 200 A et une puissance continue de 2 à 200 kVA et/ou de préférence des impulsions d'allumage sont utilisées en cas d'excitation de l'atmosphère gazeuse contenant de l'azote au moyen d'un plasma de décharge à courant continu pulsé dans une ou plusieurs des étapes de nitruration.

7. Procédé selon une ou plusieurs des revendications 1 à 6, **caractérisé en ce que** dans une ou plusieurs des étapes de nitruration, le plasma de décharge est généré à l'aide d'une électrode de grille active et les pièces sont maintenues de préférence à un potentiel électrique négatif par rapport à une électrode de grille active avec une valeur de 10 à 400 V, en particulier de 10 à 200 V.

8. Procédé selon une ou plusieurs des revendications 1 à 5, **caractérisé en ce que** l'implantation ionique par immersion plasma est utilisée dans une ou plusieurs des étapes de nitruration.

9. Procédé selon une ou plusieurs des revendications 1 à 8, **caractérisé en ce que** les pièces sont maintenues pendant les étapes de nitruration à des températures de 820 à 1000 °C, de préférence de 920 à 980 °C et/ou les pièces sont maintenues pendant les étapes de carburation à des températures de 940 à 1050 °C.

10. Procédé selon une ou plusieurs des revendications 1 à 9, **caractérisé en ce que** dans les étapes de nitruration, l'atmosphère gazeuse contenant de l'azote se compose de N₂ et le cas échéant d'un ou plusieurs gaz porteurs, tels que H₂ et l'argon.

11. Procédé selon une ou plusieurs des revendications 1 à 9, **caractérisé en ce que** dans les étapes de nitruration, l'atmosphère gazeuse contenant de l'azote se compose de N₂ et d'un ou plusieurs gaz contenant du carbone, tels que CO₂ ou CH₄ ainsi que le cas échéant un ou plusieurs gaz porteurs, tels que H₂ et l'argon et la part des gaz contenant du carbone, par rapport à N₂, est de préférence 2 à 20 % vol., de manière particulièrement préférée 4 à 15 % vol. et en particulier 4 à 10 % vol.

12. Procédé selon une ou plusieurs des revendications 1 à 11, **caractérisé en ce que** dans les étapes de nitruration, la pression de l'atmosphère gazeuse contenant de l'azote est inférieure à 40 mbar, de préférence inférieure à 30 mbar et en particulier inférieure à 20 mbar.

13. Procédé selon une ou plusieurs des revendications 1 à 12, **caractérisé en ce que** dans les étapes de carburation, l'atmosphère gazeuse contenant du carbone se compose d'un ou plusieurs gaz distributeurs contenant du carbone, tels que C₂H₂, CO₂ et CH₄ et le cas échéant un ou plusieurs gaz porteurs, tels que H₂ et l'argon et la pression de l'atmosphère gazeuse contenant du carbone est de préférence inférieure à 40 mbar, de manière particulièrement préférée inférieure à 30 mbar et en particulier inférieure à 20 mbar.

14. Procédé selon une ou plusieurs des revendications 1 à 13, **caractérisé en ce que** le procédé comprend une étape de diffusion haute pression dans une atmosphère N₂ avec une pression de 0,9 à 2 bar et de préférence dans l'ordre séquentiel les étapes de
- nitruration/carburation/diffusion haute pression.

15. Dispositif de durcissement thermochimique de pièces, comprenant
- m chambres de chauffage basse pression avec m = 2, 3, 4, 5, 6, 7, 8, 9 ou 10;
- une alimentation en gaz raccordée aux chambres de chauffage basse pression, qui est aménagée pour alimenter les chambres de chauffage basse pression en un ou plusieurs gaz, sélectionnés dans le groupe comprenant N₂, des gaz distributeurs contenant du carbone, tels que C₂H₂, CO₂ et CH₄ et des gaz porteurs, tels que H₂ et l'argon ;
- une chambre de transfert, à laquelle chacune des chambres de chauffage basse pression ainsi qu'un sas et une chambre de trempe et ou un sas-chambre de trempe bifonctionnel est attaché ; ou
- un sas et une chambre de trempe, qui sont respectivement déplaçables et peuvent être reliés à chacune des chambres de chauffage basse pression ; ou
- un sas-chambre de trempe bifonctionnel, qui est déplaçable et peut être relié à chacune des chambres de chauffage basse pression ;
**caractérisé en ce que**
une ou plusieurs des chambres de chauffage basse pression sont reliées à une alimentation en énergie électrique et aménagées pour générer dans une atmosphère gazeuse contenant de l'azote avec N₂ en tant que gaz distributeur à des températures supérieures à 800 °C et des pression inférieures à 100 mbar, un plasma de décharge avec une tension continue de 200 à 1000 V, un courant continu de 10 à 200 A et une puissance continue de 2 à 200 kVA.

16. Dispositif selon la revendication 15, **caractérisé en ce que** l'alimentation en énergie électrique est aménagée pour le fonctionnement avec une tension continue pulsée, de préférence en relation avec des impulsions d'allumage.

17. Dispositif selon la revendication 15 ou 16, **caractérisé en ce qu'**une ou plusieurs des chambres de chauffage basse pression sont équipées d'une électrode de grille active.
